Europäisches Patentamt

European Patent Office

Office européen des brevets

(11) Veröffentlichungsnummer: **0 275 006**
**A2**

## (12) EUROPÄISCHE PATENTANMELDUNG

(21) Anmeldenummer: 88100024.4

(51) Int. Cl.⁴: **H01L 31/06**, H01L 25/04

(22) Anmeldetag: 04.01.88

Die Bezeichnung der Erfindung wurde geändert (Richtlinien für die Prüfung im EPA, A-III, 7.3).

(30) Priorität: 13.01.87 DE 3700792

(43) Veröffentlichungstag der Anmeldung:
20.07.88 Patentblatt 88/29

(84) Benannte Vertragsstaaten:
AT CH DE ES FR GB IT LI SE

(71) Anmelder: **Hoegl, Helmut Dr.**
**Seitnerstrasse 28**
**D-8023 München-Pullach(DE)**

Anmelder: **Kern, Ralf M.**
**Assenbucherstrasse 67**
**D-8137 Berg-Leoni(DE)**

(72) Erfinder: **Hoegl, Helmut Dr.**
**Seitnerstrasse 28**
**D-8023 München-Pullach(DE)**
Erfinder: **Kern, Ralf M.**
**Assenbucherstrasse 67**
**D-8137 Berg-Leoni(DE)**

(74) Vertreter: **Kern, Ralf M., Dipl.-Ing. et al**
**Kern, Lang & Partner Patent- und**
**Rechtsanwaltsbüro Postfach 14 03 29**
**D-8000 München 5(DE)**

(54) **Solarzellenelement rings um eine langgestreckten Elektrode, Anordnung und Herstellungsverfahren.**

(57) Eine Solarzellenanordnung und ihre vorzugsweise faden-bzw. drahtförmigen Solarzellen-Elemente erlauben einen aus unterschiedlichen photovoltaisch wirksamen, anorganischen und organischen Materialien bestehenden Aufbau sowie vielseitig variable Kombinationsmöglichkeiten bei sowohl wirtschaftlicher Herstellung und erhöhtem Wirkungsgrad.

EP 0 275 006 A2

Die Erfindung betrifft eine Solarzellenanordnung mit mehreren Solarzellen-Elementen, welche eine photovoltaische Schicht rings um eine langgestreckte Elektrode herum aufweisen, eine zugehörige Elektrodenanordnung sowie ein Verfahren zur Herstellung solcher Solarzellen.

Bei bekannten photovoltaischen Zellen (nachstehend kurz Solarzellen genannt) schattet diejenige Elektrode, welche auf der dem Sonnenlicht zugewandten photoelektrisch wirksamen Schicht angebracht ist, den freien Lichteinfall erheblich ab. In einer transparenten, elektrisch leitenden, auf der Lichteinfallseite angeordneten Deckschicht als Elektrode oder als Teil davon wird ein großer Lichtanteil vor dem Auftreffen auf die photoelektrisch wirksamen Schichten absorbiert.

Bei der Ableitung der photovoltaisch erzeugten elektrischen Ladungen vom konkreten Entstehungsort zur metallischen Elektrode enstehen durch die seitlich quer durch die Halbleiter-schichten hindurch verlaufenden Ladungspfade sowohl erhebliche Spannungs - bzw. Stromwärmeverluste, als auch große Rekombinationsverluste. -

Aufgabe der Erfindung ist es, diese - und weitere -Nachteile bekannter Solarzellen zu vermeiden bzw. zu vermindern und zudem eine vereinfachte und wirtschaftlichere sowie mit höherer Wirksamkeit arbeitende Energiegewinnung mittels Solarzellen zu ermöglichen.

Demgemäß besteht die Erfindung vornehmlich in einer Solarzellenanordnung der eingangs genannten Art, die dadurch gekennzeichnet ist, daß jedes faden-bzw. drahtförmig ausgebildete Solarzellen-Element als ganzes für sich eine einzelne, gesonderte Spannungszelle mit einer Gegenelektrode bildet.

Diese erfindungsgemäßen Solarzellen sind nachstehend generell als "faden-bzw. drahtförmige Solarzellen" bezeichnet. Sie besitzen in ihrer Mitte eine elektrisch leitende, faden-bzw drahtförmigen Elektrode, insbesondere z.B. aus dünnem Metalldraht oder metallisierten Gewebefäden, welche mit photovoltaisch wirksamem Halbleitermaterial beschichtet ist, wobei das gegenpolige Abgreifen der unter Lichteinfluß im Halbleitermaterial entstandenen elektrischen Ladungsträger an dessen radial äußerer Mantelfläche derart erfolgt, daß sich je Solarzellen-Element nur zwei gegenpolige Anschlüsse ergeben, nämlich einer an der Elektrode in der Mitte der Solarzelle - nachstehend Mittelelektrode genannt - und einer an der Außenseite der faden-bzw. drahtförmigen Solarzelle - und daß nicht etwa eine über die Längserstreckung der Zelle vorgesehene Unterteilung dieser Zelle in eine Vielzahl von Zellabschnitten vorgesehen ist.

Der Begriff "faden-bzw. drahtförmig" schließt jede Querschnittsform der Mittelelektrode und der Halbleiterbeschichtung bzw. der äußeren Form der faden-bzw. drahtförmigen Solarzelle ein. Er umfasst beispielsweise auch sowohl eine einfädige oder mehrfädige Mittelektrode als auch eine flexible bzw. biegsame oder steife bzw. halbsteife Ausbildung der faden-bzw. drahtförmigen Solarzelle.

Mit den erfindungsgemäßen fadenförmigen Solarzellen der erfindungsgemäßen Art wird im Vergleich zu plattenförmigen Solarzellen auf der dem Lichteinfall ausgesetzten Fläche eine um den Faktor $\pi$ (Pi) (Faktor (3,14)) größere photowirksame Grenzschicht -bzw. Sperrschichtfläche, d.h. eine entsprechend höhere Stromleistung erreicht, bei zugleich kürzesten Strompfaden innerhalb der Zelle, nämlich linear radial einwärts bzw. auswärts zwischen Mittelelektrode und äußerer Zellenbegrenzung. Durch die Mittelektrode wird mindesten 50% der derart erfindungsgemäß vergrößerten Solarzellen-Grenzschichtfläche unbeschattet dem Lichteinfall ausgesetzt - zudem vorzugsweise auch in zylindrischer Form, d.h. von sich aus senkrecht zum Lichteinfall. Durch die die Mittelelektrode umhüllende Anordnung des photoaktiven Halbleitermaterials gewährleistet auch die übrige -hinter der Mittelelektrode liegende - Umfangsfläche der Grenzschicht der erfindungsgemäßen Solarzelle bevorzugt unter Lichtbrechung die photovoltaische Ausnutzung des eingefallenen Lichts. Aus ähnlichem Grunde kann die Oberfläche der faden-bzw. drahtförmigen Mittelelktrode auch metallisch verspiegelt sein.

Die erfindungsgemäßen faden-bzw. drahtförmigen Solarzellen sind einerseites kontinuierlich mit Höchstgeschwindikeit herstellbar, sowie zu den verschiedensten Parallel-Lagen und Geweben bzw. Vliesen und anderen Anordnungen kombinierbar und andererseits auch für die Verwendung nicht nur anorganischer, sondern vor allem auch organischer photovoltaisch wirksamer Stoffe bzw. Materialien anstelle der bisher allein verwendeten anorganischen Halbleitermaterialien einsetzbar. Gerade die Faden-bzw. Drahtform ist eine besonders vorteilhafte formmäßige Anpassung des Solarzellenaufbaus an derartige organische Materialien, welche nicht nur billiger in der Herstellung sind, sondern auch nahezu beliebig verformbar sowie in geringsten Schichtdicken herstellbar. Damit ist es mit den erfindungsgemäßen faden-bzw. drahtförmigen Solarzellen auch möglich, diese z.B. in Form von Beschichtungen mit z.B. einem Gewebe daraus zum Bestandteil von Konstruktionselementen zu machen. Dazu würde die Auskleidung - oder auch die Verwendung als tragende Elemente - von sogar auch rund geformten Wandelementen von Windenergie-Rotoren, beispielsweise von Savonius-Windgeneratoren, zu rechnen sein.

Da die photovoltaisch wirksame Beschichtung mit organischen Materialien noch dünner oder auf einfache Weise auch dicker als bei polykristallinen oder amorphen anorganischen Materialien sein kann, ergibt sich auch die Möglichkeit der Erhöhung des Absorbtionskoeffizienten. Mit derartig dünnen, d.h. nur

wenige μm dicken Beschichtungen einer Mittelelektrode kann der Querschnitt der fadenförmigen Solarzelle vorwiegend von der Mittelelektrode eingenommen werden. Mit den herkömmlichen Techniken mit der auf der Lichteinfallseite angebrachten Elektrode sind derartig dünne Schichten kontaktmäßig nicht beherrschbar. Auch gewährleisten organische photovoltaisch wirksame Solarzellenschichten eine festere und dichtere Haftung an den Elektrodenoberflächen.

Als Material für die Mittelelektrode eignen sich z.B. elektrisch hochleitende Carbonfasern oder Metallfäden bzw. -drähte (z.B. aus Ag, Cu, Al, Fe, W, Ni, Zn etc.) oder deren und andere elektrisch leitende Legierungen. Eine Mittelelektrode kann auch aus mit Metallen oder Zinndioxid überzogenen Glasfasern oder z.B. auch aus nach bekannten Verfahren hergestellten metallisierten Textilfasern bestehen. Dabei können die Metallschichtdicken zwischen 0,5 bis 25 μm liegen und darüberhinaus noch elektrochemisch verstärkt sein.

Als ANORGANISCHES Halbleitermaterial kommen die dafür bekannten Materialien wie Selen, Silizium, Kupferoxid ($Cu_2O$), Kupfersulfid ($Cu_2S$) und Cadmiumsulfid (CdS) etc. insbesondere in der bekannten p-und n-dotierten flächigen Doppelschichtform in Frage.

Als erfindungsgemäß verwendete ORGANISCHE photovoltaisch wirksame Stoffe bzw. Halbleitermaterialien sind einerseits **niedermolekulare** photoaktive DONOR-Verbindungen einsetzbar.

Es hat sich herausgestellt, daß fast jede organische aromatische bzw. heterocyclische Substanz ohne oder mit elektronenabgebenden Substituenten für eine erfindungsgemäße Verwendung geeignet ist, ausgenommen evtl. hygroskopische Substanzen. Elektronenabgebende Molekülgruppen sind bekanntlich Alkyl-, Alkoxy-, Aminogruppen usw. Als aromatische Donor-Substanzen kommen beispielsweise Anthracen, Chrysen, Pyren und Triphenylamin in Frage, als geeignete heterocyclische Donor-Substanzen z.B. Carbazol und 2-Bis-(4'-diäthylaminophenyl)-1,3,4-oxidiazol.

Erfindungsgemäß mussen diese Verbindungen mit Hilfe inerter Bindemittel auf die Mittelelektrode bzw. auf die innere photoaktive Schicht aufgetragen werden.

**Hochmolekulare** bzw. **polymere** DONOR-Substanzen haben den für die erfindungsgemäße Verwendung den besonderen Vorteil, daß sie auch ohne zusätzliche Binderharze aufgetragen werden können. Typische Vertreter dieser Klasse sind die Polyvinyl-Aromaten und -Heterocyclen sowie Polymerisate und Mischpolymerisate von aromatischen Substanzen, die an einem ankondensierten Ring eine Doppelbindung tragen, z.B. Poly-2-vinylnaphthalin, Poly-3-vinyl-pyren, Poly-N-vinylcarbazol, Pol-acenaphthylen.

Erfindungsgemäß verwendete ORGANISCHE **niedermolekulare** photoaktive AKZEPTOR-Verbindungen sind vorzugsweise Substanzen, die start elektronegativ polarisierende Reste bzw. Gruppierungen tragen, wie die Cyan-und die Nitrogruppe; Halogene wie Fluor, Chlor, Brom, Jod; Ketongruppen, Estergruppe, Säureanhydrid-Gruppe; Säuregruppen wie Carboxylgruppe oder die Chinongruppierung. Die aromatischen und heteroaromatischen Akzeptor-Substanzen sind selbst photoaktiv, insbesondere, wenn sie mit geeigneten Donoren (wie vorstehend angegeben) dotiert werden. Sind die Akzeptor-Substanzen niedermolekular aufgebaut, d.h. also nicht harzartig, so erfordern sie zu ihrer Aufbringung als photoaktive Schichten des Zusatzes von geeigneten, inerten Binderharzen.

Typische Beispiele von Elektron-Akzeptoren sind 1,5-Dinitronaphtalin, 2,4,7-Trinitrofluorenon, 4,7-trinitrofluorenon, Tetrachlor-phthalsäureanhydrid, 1,2-Benzo-anthrachinon, 9-Acetyl-anthracen und s-Tricyanobenzol.

**Hochpolymere** AKZEPTOR-Substanzen, die stark elektronegativ polarisierende Reste enthalten, sind weniger häufig. Schwache Akzeptor-Polymere sind z.B. die aromatischen Polyester (wie das Polyäthylenglykolterephthalat) und die Polycarbonate.

Erfindungsgemäß ist insbesondere auch vorgesehen, anorganische Halbleitermaterialien und photoaktive organische Substanzen z.B. derart miteinander zu kombinieren, daß eine anorganische DONOR-Schicht mit einer organischen AKZEPTOR-Schicht (hoch-oder niedermolekular) eine Sperrschicht-Anordnung bildet bzw. umgekehrt eine DONOR-Schicht aus organischem Material mit einer AKZEPTOR-Schnicht aus anorganischen Material. Auch die Einfügung von Zwischenschichten aus intrinsisch wirksamen, undotierten (i-) Schichten kann aus organischem und/oder anorganischem Material kombiniert erfolgen.

Die photovoltaische Wirkung der vorgenannten Halbleitermaterialien insbesondere jedoch der erfindungsgemäß verwendeten organisch photovoltaisch wirksamen Materialien kann erfindungsgemäß durch Einsatz von Farbsensibilisatoren verbessert werden.

Farbsensibilisatoren, die zur Verschiebung der Empfindlichkeit vom ultravioletten Bereich ins sichtbare Licht geeignet sind, weisen im allgemeinen selbst photoelektrische Eigenschaften auf, d.h. sie sind photoleitend und besitzen photovoltaische Eigenschaften. Ihre Dunkelleitfähigkeit ist jedoch generell höher als die der farblosen bzw. schwachgefärbten photoelektrischen Substanzen.

Die Farbsensibilisatoren haben schon in sehr geringen Farbstoffmengen, beispielsweise von wenger als 0,01 Gewichtsprozent, sensibilisierende Effekte. Im allgemeinen setzt man den photoaktiven Schichten erfindungsgemäß jedoch 0,01 bis 5 Gewichtsprozent, vorzugsweise 0,05 bis 3 Gewichtsprozent, Farbsensibilisator zu.

Als gut, teilweise sehr gut brauchbare Farbsensibilisatoren eignen sich z.B.:

Triarylmethanfarbstoffe, wie Brillantgrün, Methylviolett;

Xanthenfarbstoffe, wie Rhodamin B, Rhodamin 6G;

Phthaleine, wie Eosin A, Rose bengale und Fluorescein;

Thiazinfarbstoffe wie Methylenblau;

Acridinfarbstoffe, wie Acridingelb, Acridinorange und Trypaflavin;

Chinolifarbstoffe, wie Pinacyanol und Kryptocyanin;

Cyaninfarbstoffe, wie Cyanin, usw.

Erfindungsgemäß ist auch die Verwendung von Aktivatoren zur Sensibilisierung der photoaktiven Substanzen vorgesehen, welche sich besonders in Kombination mit organischen photoaktiven Substanzen einsetzen lassen.

Aktivatoren weisen selbst keine photoelektrischen Eigenschaften auf, vermögen jedoch die Lichtempfindlichkeit photoaktiver Substanzen oft ganz beträchtlich zu steigern. Sehr viele photoaktive Substanzen absorbieren das Licht bevorzugt im ultravioletten Bereich (wie z.B. Polyvinyl-carbazol und Polystryol). Mann kann ihre Empfindlichkeit dadurch steigern, daß man aktivierende Substanzen zufügt, die mit ihnen sog. Charge-transfer-Komplexe zu bilden vermögen. Sie kommen erfindungsgemäß in· Molekülkomplexen des Donor-Akzeptor-Typs (Charge-transfer-Komplexe) entweder als Elektron-Donoren ("Lewis-Säuren", wie z.B. Chlorwasserstoff HCl, organische Carbon-und Sulfonsäuren, Metallhalogenide) oder als Elektron-Akzeptoren ("Lewis-Basen", wie z.B. Natriumhydroxid NaOH, Ammoniumverbindungen) in Frage.

Die Aktivatormenge, die man den photovoltaischen Stoffen zweckmäßig zusetzt, schwankt je nach dem Trägersubstrat und beträgt im allgemeinen etwa 0,01 bis 100 Mol, bezogen auf 1000 Mol der photoaktiven Substanz. Es können auch Gemische mehrerer Aktivatoren verwendet werden. Ferner können zusätzlich auch noch Sensibilisator-Farbstoffe zugesetzt werden.

Man kann erfindungsgemäß durch Zugabe dieser aktivierenden Substanzen photoleitfähige Schichten herstellen, die eine hohe Lichtempfindlichkeit, besonders im ultravioletten Bereich, besitzen und die praktisch farblos sind. Es besteht somit die Möglichkeit, mit ihrer Hilfe die photoaktiven Schichten im ultravioletten Bereich stark zu aktivieren und dann durch einen sehr geringen Zusatz von Farbsensibilisator auch eine hohe Empfindlichkeit im sichtbaren Licht zu erhalten, ohne daß soviel Farbsensibilisator zugegeben werden muß, daß die Schicht stark gefärbt ist.

Der erfindungsgemäße Einsatz organischer photovoltaischer Verbindungen ergibt eine sehr große Fülle von Kombinationsmöglichkeiten auch mit Aktivatoren und/oder Farbsensiblisatoren. Dies ist von großem Vorteil für die optimale Nutzung der verfügbaren Lichtstrahlen. Die organischen Substanzen können sowohl als Einzelschichten mit anorganischen photoaktiven Schichten eingesetzt werden. Es ergeben sich so die nachfolgenden Kombinationen (PVCa = Poly-N-vinylcarbazol, TNF = 2,4,7-Trinitrofluorenon mit einem geeigneten Kunststoff-Bindemittel, Chlorwasserstoffsäure und Natriumhydrocid = typische Lewis-Säure bzw. Lewis-Base, Rhodamin B und Methylenblau = willkürlich gewählter Farbensensibilisator)

## Photoaktive Einzelschichten

| Nr. | Photoaktives Substrat | Dotierungsmittel | Aktivierungsmittel | Farbsensibilisator |
|---|---|---|---|---|
| 1 | PVCa-Donor | – | – | – |
| 2 | PVCa-Donor | TNF-Akzeptor | – | – |
| 3 | PVCa-Donor | – | HCl-Säure | – |
| 4 | PVCa-Donor | – | – | Rhodamin B |

4

| | | | | |
|---|---|---|---|---|
| 5 | PVCa-Donor | TNF-Akzeptor | HCl-Säure | – |
| 6 | PVCa-Donor | TNF-Akzeptor | HCl-Säure | Rhodamin B |
| 7 | PVCa-Donor | – | HCl-Säure | Rhodamin B |
| 8 | PVCa-Donor | TNF-Akzeptor | – | Rhodamin B |
| 9 | TNF-Akzeptor | – | – | – |
| 10 | TNF-Akzeptor | PVCa-Donor | – | – |
| 11 | TNF-Akzeptor | – | NaOH-Base | – |
| 12 | TNF-Akzeptor | – | – | Methylenblau |
| 13 | TNF-Akzeptor | PVCa-Donor | NaOH-Base | – |
| 14 | TNF-Akzeptor | PVCa-Donor | NaOH-Base | Methylenblau |
| 15 | TNF-Akzeptor | – | NaOH-Base | Methylenblau |
| 16 | TNF-Akzeptor | PVCa-Donor | – | Methylenblau |

Die oben erwähnten Donor-Schichten können erfindungsgemäß mit den erwähnten Akzeptor-Schichten zu Doppelschichten miteinander kombiniert werden, die ihrerseits höhere Lichtempfindlichkeiten aufweisen als die Einzelschichten. Außerdem können organische Donor-Schichten mit anorganischen Akzeptor-Schichten kombiniert werden, wie z.B. Selenschichten mit PVCa-Schichten. Umgekehrt können anorganische Akzeptor-Schichten mit organischen Donor-Schichten zu Doppelschichten kombiniert werden.

Um bei den organischen Substanzen einen Volumen-Effekt wie bei den bekannten Sperrschichtphotozellen aus anorganischen Stoffen (z.B. aus Silizium) zu erzielen, muß man einen mindestens einige Hundertstel bis etwa zehn Mikrometer von der Oberfläche entfernten pnübergang schaffen. Der Leitungstyp der Schicht wird deshalb innerhalb eines Volumenbereichs nahe der Oberfläche in den entgegengesetzten Leitungstyp umgewandelt. Auf diese Weise ist es möglich, bei der Umwandlung von optischer in elektrische Energie sehr günstige Ausbeuten zu erreichen.

Dies wird erfindungsgemäß beispielsweise durch die folgenden Kombinationsanordnungen erreicht.

### Photoaktive Doppelschicht-Fadenzellen

| | Mittel-elektrode | Photoaktive Schichten | | Äußere Gegen-elektrode der Fadenzelle | Transparente Schutz-hülle |
|---|---|---|---|---|---|
| | | innen | außen | | |
| 1 | Cu-Draht | PVCa-Donorschicht + Zusätze wie oben | TNF-Akzeptor-schicht + Zusätze | wendelförmig aufgebrachter Leitlack | Poly-methyl-methacry-lat |
| 2 | Aluminium-draht, mit Cadmium überzogen | Selen-Akzeptor (aufgedampft) | PVCa-Donor-schicht + Zusätze | aufgedampfter Zinndioxid-Leitkontakt | Poly-butyl methacry-lat durch Glimment-ladung |
| 3 | Aluminium-draht | Amorphes Silizium aufgedampft p-leitend durch Bor-Dotierung | TNF-Akzeptor-schicht + Zusätze | Leitlack | Poly-methyl-methacry-lat |

Die erfindungsgemäße Solarzellen-Anordnung, insbesondere die erfindungsgemäße Schaltungs-Zuordnung von parallel nebeneinander angeordneten Mittelelektroden bzw. faden-oder drahtförmigen Solarzellen erlaubt zudem eine erweiterte Kombinationsmöglichkeit von p-i-n-Schichtanordnungen, d.h. also die Einfügung einer bekannten, vorzugsweise völlig undotiert wirkenden intrinsischen (i-) Schicht jeweils im übergang von der p-zur n-Schicht bzw. von der n-zur p-Schicht oder in Form von Tandem-(also 2-fach Serienschaltungs-) Anordnungen, d.h. also als (Elektrode-p-n-i-p-n-Elektrode) - Schichtanordnung z.B. zwischen jeweils zwei nebeneinander liegenden Mittelelektroden, welche auf diese Weise zu Gegenelektroden voneinander werden. In dieser Schichtanordnung kann auch jeweils zwischen der p-und der n-Schicht d.h. als verstärkte Sperrschicht noch eine weitere intrinsische (i-) Schicht vorgesehen sein.

Diese Solarzellen-Ausführung wird erfindungsgemäß durch eine Elektroden-Anordnung erreicht, bei der parallel nebeneinander oder auch übereinander und im Winkel zueinander liegende faden-bzw. drahtförmige Mittelelektroden über ihre umhüllenden photoaktiven Schichten elektrisch miteinander verbunden sind.

Alternativ dazu kann die erfindungsgemäße Elektroden-Anordnung auch darin bestehen, daß den parallel nebeneinander liegenden faden-bzw. drahtförmigen Mittelelektroden eine auf der dem Lichteinfall abgewandten Seite angeordnete flächige Gegenelektrode gemeinsam zugeordnet ist, welche über mindestens den größten Teil der Längserstreckung der Solarzellen mit der Außenseite ihrer Halbleitermaterial-Umhüllung elektrisch leitend verbunden ist. Dies gilt auch dann erfindungsgemäß, wenn die flächige Gegenelektrode längs in Streifen bzw. Bänder unterteilt ist.

Wenn die faden-bzw. drahtförmigen Solarzellen-Elemente erfindungsgemäß in gewebter bzw. geflochtener Anordnung miteinander verbunden sind, dann können die Schuß-und die Kettfäden im Querschnitt auch in jeweils entgegengesetzter p-n-Schichtanordnung (oder p-i-n-Schichtanordnung) aufgebaut sein, sodaß sich über die Schuß-und Kettfädenkontaktpunkte eine Tandem-Schaltung ergibt und die Mittelelektroden beider Fadenarten an jeder Fadenkreuzung in Serie geschaltet sind. Dafür können die Kettfäden oder die Schußfäden (oder auch beide) zusätzlich mit einer Außenschicht aus intrinsischem (i-) Material versehen sein, über die der Tandemkontakt stattfinden kann. Auch kann an diesen Gewebe-Kreuzungspunkten eine Verschmelzung bzw. elektrisch leitende feste Verbindung der sich jeweils kreuzenden Fäden gegeben sein.

In einfachster Form jedoch kann ein erfindungsgemäßes Gewebe in Schuß-und Kettrichtung aus gleich aufgebauten faden-bzw. drahtförmigen Solarzellen-Elementen aufgebaut sein, welche mit der Außenseite ihrer Halbleiterschicht-Umhüllung elektrisch mit einer (auf der lichtabgewandten Seite angeordneten) - vorzugsweise flächigen, auch folienartigen - Gegenelektrode elektrisch verbunden sind.

Bei einzelnen, lediglich nebeneinander angeordneten erfindungsgemäßen Solarzellen-Elementen kann die Gegenelektrode auf der dem Lichteinfall abgewandten Umfangs-Außenfläche in Form einer Metallisierung vorgesehen sein, welche reflektrierend ähnlich einem Hohlspiegel wirkt.

Auch die vorgenannten, vorzugsweise flächigen, Gegenelektroden können reflektierend ausgeführt sein. Die insbesondere im Querschnitt runde bzw. konvexe Form der Oberfläche eines Solarzellen-Elements gewährleistet einerseits einen auf den Sonnenstand stets senkrecht, d.h. reflexionsfrei ausgerichteten Oberflächenabschnitt als auch andererseits eine Absorbtion des aufgenommenen Lichts durch Reflexion an den Grenzschichten der Innenbereiche des Solarzellen-Elements. Dafür lassen sich aber auch andere Querschnittsformen der Solarzellen-Elemente bilden, beispielsweise mit ovalem oder prismenförmigen Querschnitt. Die Verwendung kombinierter organischer und/oder anorganischer Solarzellenschichten vergrößert zudem die Auswahl von Stoffen mit hohem Unterschied im Brechungsindex und damit eine verbesserte Nutzung der Totalreflexion einmal aufgenommenen Lichts.

Als Gegenelektrode kann zudem auch ein elektrisch leitender Faden oder Draht vorgesehen sein, um den ein faden-bzw. drahtförmiges Solarzellen-Element wendelförmig herumgewickelt ist.

Mehrere faden-bzw. drahtförmige Solarzellen-Elemente können auch (im Querschnitt gesehen) ringförmig bzw. als Bündel um eine dazu zentral angeordnete Gegenelektrode angeordnet sein, deren elektrisch leitende Oberfläche jeweils längs an den Außenseiten der Solarzellen-Elemente anliegt.

Derartige zusammengesetzte Anordnungen von Solarzellen-Elementen können auch seilartig ineinander verdreht sein, wobei die Gegenelektrode ähnlich einer Kabelseele angeordnet ist.

In besonders vorteilhafter Ausführungsform kann die äußere Gegenelektrode auch aus einem elektrisch leitendem Kunststoff bestehen, wofür sowohl leitfähige Polymercompounds als Polymere mit sog. intrinsischer elektrischer Leitfähigkeit verwendet werden können. Die leitfähigen Polymercompounds sind Kunststoffe mit eingearbeiteten leitfähigen Füllstoffen, wie z.B. Aluminiumpulver, Graphitpulver oder Ruß, und Stahlfasern. Als intrinsisch leitfähige Kunststoffe kommen mit geeigneten Elektronendonatoren (z.B. Metallatome) bzw. Elektronen-Akzeptoren (z.B. Jod-Atomen) dotierte Kunststoffe, wie z.B. Poly-acetylen, Poly-pyrrol, Poly-paraphenylen, Poly-phenylen-sulfid, Poly-thiophen sowie polymere Metallkomplexe des Phthalocyanins, insbesondere auch Coextrudate des Aramid-Polymers Kevlar mit Phthalocyanin-Polymeren.

Zwecks verstärkter flächenartiger Nutzung können erfindungsgemäß auch mehrere Parallel-Lagen von Solarzellen-Elementen schichtartig übereinander angeordnet sein, und zwar vorzugsweise derart, daß die Mittelelektroden der übereinander befindlichen Schichten auf Lücke versetzt zueinander liegen. Dabei können die verschiedenen Lagen zwecks vollständiger Nutzung des Licht-Wellenspektrums sowohl aus unterschiedlichen Halbleitermaterialien bestehen, als auch verschiedene Fadendurchmesser aufweisen.

6

Dazu kann als Gegenelektrode wieder eine auf der lichtabgewandten Seite angebrachte elektrisch leitende -und gegebenenfalls reflektierende - Fläche vorgesehen sein.

Alternativ dazu können die einzelnen Mittelelektroden entweder der übereinander liegenden Schichten als auch der nebeneinander angeordneten Solarzellen-Elemente bei entsprechender p-n-bzw. n-p-Beschichtung bzw. p-i-n oder n-i-p Beschichtung auch wechselweise zueinander als Gegenelektrode in Tandem-Schaltung dienen.

Sowohl einzelne als auch auf die vorgenannte Weise kombinierte faden-bzw. drahtförmige Solarzellen-Elemente können andererseits zur Isolation gegeneinander bzw. als elektrischer Schutzüberzug mit einem Deck-oder Isolierharz versehen sein, welcher auch gegen oxidativen Abbau und Lichtalterung wirksam ist.

Mittels Polymerisation z.B. der Monomere Methylmethacrylat, n-Buthylmethacrylat oder Äthylsilikat durch Glimmentladung wird die photoaktive Schicht, gegebenenfalls einschl. ihrer Gegenelektrode, erfindungsgemäß mit einer festen, durchgehend polymerisierten und homogenen dieelektrischen Schicht von 0,01 bis 1 Mikrometer mit hohem Widerstand überzogen.

Dieser Schicht können erfindungsgemäß zur Erhöhung des Wirkungsgrades auch Fluoreszenzfarabstoffe beigefügt sein, die eine Wellenlängentransformierung in den Absorptiosbereich der photoaktiven Sperrschicht bewirken.

Für die Herstellung eines elektrisch isolierenden Schutzüberzugs kann jedes geeignete transparente und nichtleitende natürliche und künstliche Harz herangezogen werden. Als elektrisch isolierende Kunststoffe kommen erfindungsgemäß sowohl thermoplastische Polymere als auch härtbare Form-und Pressmassen in Frage, wie z.B. Polyäthylen und andere Polyolefine sowie Vinyl-Polymere und Copolymere, insbesondere jedoch die verschiedenen Methacrylate und halogenhaltigen Vinylpolymere, Polyäther, Polycarbonate, Polyester, Polyacetate, Polyamide, Polyimide, Polyesterimide, Polysulfone, Polyurethane, Silikonharze, Zellulose-Derivate. Des weiteren die Phenoplaste, Aminoplaste, Alkyd-Harze, Polyesterharze, ungesättigte Polyester, Epoxid-Harze.

Die erfindungsgemäß angeordneten faden-bzw. drahtförmigen Solarzellen lassen sich auch in verschiedensten anderen Formen verwenden, so z.B. als Außenwand-und Innenwandauskleidungen (z.B. als strukturierte Tapeten) als Gardinen zur Ausnutzung von Fensterflächen und beispielsweise auch zur Hydrolyse von Wasserstoff mit vergrößerter aktiver Elektroden-Oberfläche wie z.B. in der bekannten Fujishima-Honda-Zelle ($TiO_2$ -evtl. Strontium dotiert - bzw. mit anderen anorganischen oder organischen Halbleitern überzogene Mittelelektroden) als Anode zur Wasserstoffherstellung. Dabei erreicht man mit der erfindungsgemäßen Verwendung als Tandemzellen eine direkt für die Hydrolyse anwendbare Spannung. Für diese Verwendung eignen sich auch die erfindungsgemäßen vliesartigen Anordnungen.

Mehrere Ausführungsformen der Erfindung werden nachstehend anhand von Zeichnungen näher beschrieben.

Es zeigt:

Fig. 1 eine teilweise weggebrochene, perspektivische Darstellung einer Grund-Ausführungsform der erfindungsgemäßen Solarzellen-Anordnung,

Fig. 2 eine teils weggebrochene, perspektivische Darstellung eines erfindungsgemäßen einzelnen Solarzellen-Elements aus der Anordnung nach Fig. 1.

Fig. 3 eine Querschnitts-Darstellung einer erfindungsgemäßen Ausführungsform eines Solarzellen-Elements insbesondere nach Fig. 2.

Fig. 4 eine Querschnitts-Darstellung einer abgewandelten Ausführung eines erfindungsgemäßen Solarzellen-Elements z.B. nach Fig. 2.

Fig. 5 eine teilweise weggebrochene perspektivische Darstellung einer abgewandelten Ausführungsform der erfindungsgemäßen Solarzellen-Anordnung.

Fig. 6 eine teilweise weggebrochene Längsschnitt-Darstellung durch eine in Form eines Gewebes abgewandelte Ausführungsform der Erfindung,

Fig. 7 eine teilweise weggebrochene perspektivische Darstellung einer weiteren Abwandlung der Erfindung,

Fig. 8 eine Draufsicht auf eine teilweise weggebrochene, schematische Darstellung einer in Form eines Vlieses abgewandelten Ausführungsform der Erfindung,

Fig. 9 einen Querschnitts-Abschnitt einer flächigen Anordnung von abgewandelten Solarzellen-Elementen der erfindungsgemäßen Solarzellen-Anordnung gemäß Fig. 1,

Fig. 10 einen Querschnitts-Abschnitt einer Anordnung einer anderen Ausführungsform von Solarzellen-Elementen der erfindungsgemäßen Solarzellen-Anordnung analog etwa gemäß Fig. 5,

Fig. 11 eine im Querschnitt wiedergegebene schematische Darstellung einer weiteren z.B. in Form eines Bündels oder eines Seils abgewandelten Ausführungsform der erfindungsgemäßen Solarzellen-Anordnung,

Fig. 12 eine schematische - im Querschnitt wiedergegebene - Darstellung einer erfindungsgemäß tandem-mäßig bzw. in Serie geschalteter Solarzellen-Anordnung mit abgewandelter Elektrodenanordnung,

Fig. 13 eine schematische - querschnittsmäßig wiedergegebene - Darstellung einer Lage von parallel zueinander angeordneten erfindungsgemäßen Solarzellen mit alternierend wechselndem Halbleiterschichtaufbau,

Fig. 14 eine Abwandlung der Ausführungsform von Fig. 13,

Fig. 15 eine weitere Abwandlung der Ausführungsform von Fig. 13,

Fig. 16 eine doppellagige Ausführungsform der Erfindung mit geändertem Fadenquerschnitt,

Fig. 17 eine erfindungsgemäße Grundform einer Anwendung einer erfindungsgemäßen Elektrodenanordnung,

Fig. 18 eine zusätzlich abgewandelte Ausführungsform der erfindungsgemäßen Elektrodenanordnung, sowie

Fig. 19 einen Teilquerschnitt durch eine weiter abgewandelte Kombinations-Ausführungsform der Erfindung.

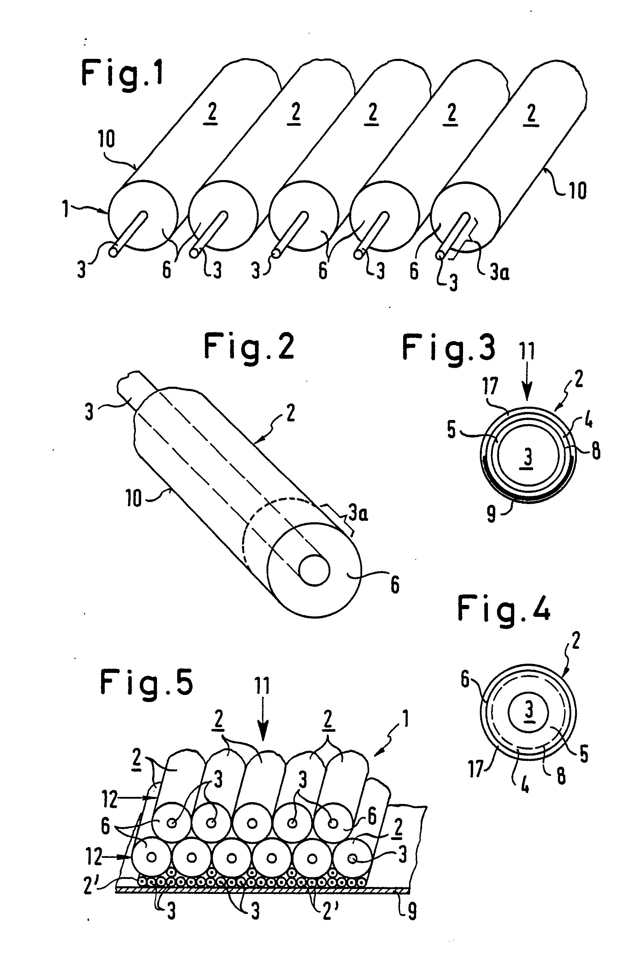

Die aus Fig. 1 ersichtliche Solarzellen-Anordnung 1 besteht aus einer Anzahl parallel nebeneinander angeordneten faden-bzw. drahtförmigen Solarzellen 2, die einander mit ihren Außenseiten 10 nicht berühren und jeweils um eine Mittelelektrode 3 eine photovoltaisch wirksame Schicht 6, z.B. aus einem Halbleitermaterial aufweisen, welche koaxial um die Mittelelektrode 3 aus verschiedenen Schichten, d.h. gemäß Fig. 3 z.B. (von der Mittelelektrode aus gerechnet) einer p-Halbleiterschicht 5, einer n-Halbleiterschicht 4, einer zwischen diesen beiden gebildeten Sperr-bzw. Übergangsschicht 8 und gegebenenfalls einer die Außenseite 10 schützende Isolationsschicht 17, welche auch die auf der Außenseite 10 der Schicht 6 gegebenenfalls vorhandene Gegenelektrode 9 umschließen kann.

Die Herstellung der faden-bzw. drahtförmigen Solarzellen erfolgt insbesondere dahingehend kontinuierlich, daß die Mittelelektrode als praktisch unendlich langer Faden nacheinander jeweils notwendige Oberflächen-Reinigungs-und Beschichtungsstationen durchläuft. Dabei wird sie zunächst z.B. mittels Glimmentladung gereinigt, dann durch Kathodenzerstäubung mit einer dünnen, elektrisch leitenden Schicht eines Haftvermittlers (z.B. Zink in einer dicke von 5mm) versehen, um einen guten elektrischen Kontakt der nachfolgend aufzubringenden lichtelektrisch wirksamen Schichten zu gewährleisten.

Die photoaktiven, d.h. photoelektrischen bzw. photovoltaischen Einzel-oder Doppelschichten 6; 4, 5 werden nacheinander in aufeinanderfolgenden Stationen als dünne, zusammenhängende, gleichmäßig dicke Schichten auf die faden-bzw. drahtförmige Mittelelektrode 2 aufgetragen.

Zur Herstellung einer photoelektrischen Schicht aus niedermolekularen photoaktiven Verbindungen löst man diese vorteilhaft in organischen Lösungsmitteln (wie Benzol, Aceton, Methylenchlorid, Äthylenglykolmonoäthyläther usw.) oder in Gemischen von solchen Lösungsmitteln. Man fügt zweckmäßig noch geeignete Bindemittel (künstliche oder natürliche Harze) zu und Dotierungsmittel sowie gegebenenfalls Farbsensibilisatoren zu. Verwendet man die photoaktiven Verbindungen in Mischungen mit harzaratigen Bindemitteln, so können die Mengenverhältnisse zwischen Harz und photoaktiver Substanz in weiten Grenzen schwanken. Gemische aus 2 Teilen Harz und 1 Teil photoaktiver Substanz bis zu Gemischen, die 2 Teile photoaktiver Substanz auf 1 Teil Harz enthalten, sind vorzuziehen. Besonders günstig sind Gemische beider Substanzen im Gewichtsverhältnis von etwa 1 : 1.

Ist die photoaktive Schicht selbst ein hochpolymerer Stoff, so erübrigt sich die Zugabe eines Bindemittels und man fügt der Lösung der polymeren photoelektrischen Substanz die gewünschten Dotierungsmittel und Farbsensibilisatoren zu.

Die Aufbringung der Beschichtung kann z.B. durch Eintauchen, Aufstreichen oder Auftragen mittels Walzen oder Aufsprühen erfolgen. Verbleibende Lösungsmittel werden durch Erwärmung entfernt.

Darüberhinaus kann die Beschichtung der Solarzellen 2 auch im Siebdruck durch Aufdampfen bzw. Aufsprühen auf die Mittelelektrode oder im Ziehverfahren durch eine Düse, aufgebracht werden. In einem Zuge im Verlauf dieses kontinuierlichen Verfahrens erfolgen auch die gegebenenfalls notwendigen Dotierungen der einzelnen Schichten an den jeweiligen Zwischenstufen der Beschichtung, ebenso eventuelle Zwischenerwärmungen, wobei vorzugsweise auch eine induktive Beheizung der jeweiligen Beschichtung und/oder über die metallische Mittelelektrode von innen her vorteilhaft sein kann.

Analog ist über die metallische Mittelelektrode wenigstens am Anfang des kontinuierlichen Verfahrens auch eine Widerstandsbeheizung durch die fadenartige Elektrode selbst möglich.

Für die Aufbringung der Gegenelektrode 9 auf die Außenseite 10 der photoaktiven Schicht 6 können verschiedene Verfahren zum Einsatz kommen., wie z.B. chemische und galvanische Metallisierungsverfahren, das Kaschieren mit Metallfolien, die Metallbedampfung, das Flammspritzen, die Kathodenzerstäubung, das Plasmaverfahren und die Verwendung von metallischen oder graphitgefüllten Anstrichstoffen.

Die im Querschnitt halbkreisförmige Gegenelektrode 9 gemäß Fig. 3kann beispielsweise mittels Aufsprühen durch eine Maske von einer Seite erfolgen, wobei die dem Sprühstrahl abgewandte Seite der fadenförmigen Solarzelle unbeschichtet bleibt. Auf diese Weise wirkt die halbkreisförmige, d.h. generell konkave Gegenelektrode 9; welche bevorzugt nach innen eine verspiegelte Oberfläche besitzt, als Hohspiegel innerhalb der Solarzelle

Nach der Fertigstellung des Schichtaufbaus der fadenförmigen Solarzelle werden die Fäden auf eine gewünschte Länge geschnitten und durch Entfernen der Beschichtung ein kurzer Kontaktbereich 3a (Fig. 1 und 2) der Mittelelektrode 3 freigelgt, an dem die Solarzelle dann elektrisch angeschlossen wird.

Je nachdem wie dick die Ummantelung 6 mit photovoltaischen Schichten ist, kann die Mittelelektrode 3 den Hauptanteil des Zellenquerschnitts einnehmen, d.h. also bei besonders dünner organischer Ummantelung 6, wobei die Mittelelektrode 3 auch in voll metallischer Ausführung litzenartig dünn und damit flexibel bzw. biegsam sein kann.

Andererseits kann gemäß Fig. 4 das Verhältnis von Schichtdicke der Ummantelung 6 zum Durchmesser der Mittelelektrode 3 auch zugunsten der Ummantelung 6 verschoben sein.

Wenn keine äußere Gegenelektrode notwendig ist, dann kann die Isolation 17 unmittelbar um die Außenseite der photovoltaischen Schicht 6 liegen.

Gemäß weiterer Ausführungsformen bedarf es dieser Isolation um die einzelnen Solarzellen aber auch überhaupt nicht.

In Fig. 5 sind mehrere Lagen von fadenförmigen, zueinander parallel angeordneter Solarzellen übereinander angeordnet. Zusätzlich zu den Parallel-Lagen 12, bei denen die einzelnen Solarzellen-Elemente 2 um eine Radiuslänge seitlich zueinander versetzt sind, damit sie sich mit ihren Mittelelektroden 3 nicht mehr als nötig abschatten, sind Soalrzellen 2' mit kleinerem Querschnitt vorgesehen, welche in den Lücken der Rundquerschnitte angeordnet sind. In der Ausführung gemäß Fig. 5 können Solarzellen mit unterschiedlicher Lichtempfindlichkeit miteinander kombiniert sein. Vorzugsweise sind die Solarzellen mit der besseren Empfindlichkeit für kurze Wellenlängen unten angeordnet.

Die Solarzellen-Elemente 2 und 2' gemäß Fig. 5 berühren sich an ihrem Außenumfang eng bzw. dicht genug, um einen störungsfreien Fluß der elektrischen Ladungen über ihre äußeren Schichten zu gewährleisten. Sie besitzen auch keine Außenisolation, sondern leiten die durch den Lichteinfall 11 erzeugten elektrischen Ladungen direkt an eine flächenartige Metall-oder metallisierte bzw. elektrisch leitende Gegenelektrode 9 ab.

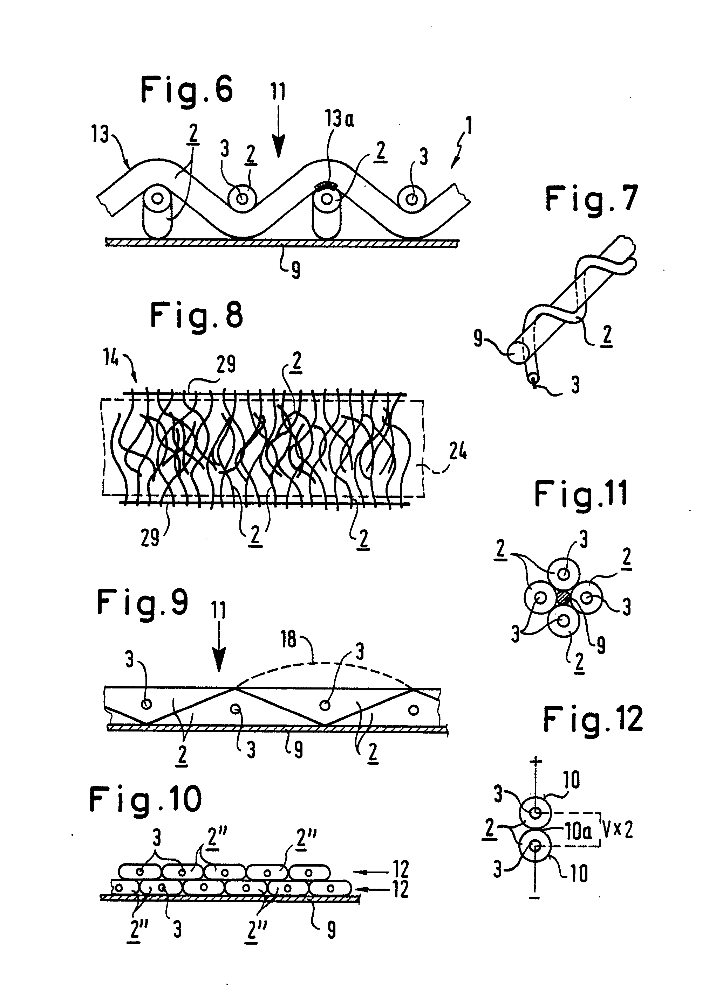

Die faden-bzw. drahtförmigen Solarzellen-Elemente 2 können gemäß Fig. 6 auch als Gewebeanordnung 13 mit Kett-und Schußfäden miteinander verbunden sein. Die einzelnen Solarzellen 2 dieser Gewebeanordnung können entweder an der Unterseite der Gewebeknoten mit einer Gegenelektrode 9 elektrisch verbunden sein, so daß die elektrischen Ladungen zwischen den Mittelelektroden 3 und der flächigen Gegenelektrode 9 (die auch reflektierend ausgeführt sein kann) fließen.

Mittels Zusammendrücken oder temperaturmäßiger Behandlung oder einem elektrisch leitenden Klebemittel können die Außenseiten der Solarzellen an den Gewebe-Knotenpunkten eine Kontaktverstärkung 13a aufweisen.

Wenn man die Kettfäden und die Schußfäden der Gewebe-Solarzellen-Anordnung gemäß Fig. 6 unterschiedlich, d.h. jeweils umgekehrt, in der Reihenfolge der Beschichtung mit den photoaktiven Schichten 4 und 5 aufbaut, dann können sie als Tandem-Zellen arbeiten (s. schematisch Fig. 12 bis 15), z.B. steht dann eine n-aktive Oberflächenschicht der Schußfaden an den Knotenpunkten mit einer p-aktiven Oberfläche der Kettfäden in elektrischem Übergangskontakt. In dieser Anordnung bedarf es der flächigen Gegenelektrode 9 nicht mehr, sondern die elektrischen Ladungsträger werden (in verdoppelter Spannung) von den Mittelelektroden 3 der Kettfäden und den Mittelelektroden 3 der Schußfäden abgenommen. In dieser Ausführungsform läßt sich die Solarzellen-Anordnung 1 auch als teilweise lichtdurchlässige Gardine ausführen.

In analoger Weise läßt sich auch eine Vlies-Anordnung 14 gemäß Fig. 8 ermöglichen. Dabei sind die Mittelelektroden 3 direkt an Stromschienen 29 angeschlossen, während die Solarzellen 2 mit ihren Außenseiten elektrisch mit einer flächigen Stromleiterbahn 24 als Gegenelektrode verbunden sind.

Gemäß den Fig. 7 und 11 ist die Gegenelektrode 9 als elektrisch leitender bzw. Metall-oder metallisierter Faden ausgebildet, welcher entweder wendelförmig um die Ummantelung jeder Solarzelle 2 gewickelt sein kann oder (Fig. 7) um den die Solarzelle 2 selbst wendelförmig gewickelt ist.

Fig. 11 zeigt seilförmig bzw. gebündelt um einen solchen Faden als Gegenelektróde 9 angeordnete fadenförmige Solarzellen 2, wobei einer Gegenelektrode 9 mehrere Mittelelektroden 3 elektrisch zugeordnet sind.

Gemäß Fig. 9 und 10 können die einzelnen Solarzellen-Elemente 2 auch anderen als runden Querschnitt besitzen. Bei prismenförmigem Querschnitt (Fig. 9) kann die Ausbildung besonderer Prismenwinkel eine vorteilhafte Innen-Totalreflexion bewirken. Dabei kann auf der Lichteinfallsseite 11 eine konvexe Oberflächenausbildung 18 vorliegen.

Die elliptische Ausbildung der Solarzellen 2″ in Fig. 10 kann auch durch nachträgliches Verpressen parallellagenmäßig 12 zusammengelegter Solarzellen-Elemente 2 mit zunächst rundem Querschnitt erreicht werden.

Der vorstehend beschriebene Schichtaufbau der Ummantelung 6 in n-und p-Schichten bzw. Halbleiterschichten 4, 5 kann um die Kombination mit einer oder mehreren intrinsichen, vorzugsweise undotierten i-Schichten 7 ergänzt werden, wozu sich gerade der fadenförmige Aufbau der Solarzellen 2 besonders gut eignet.

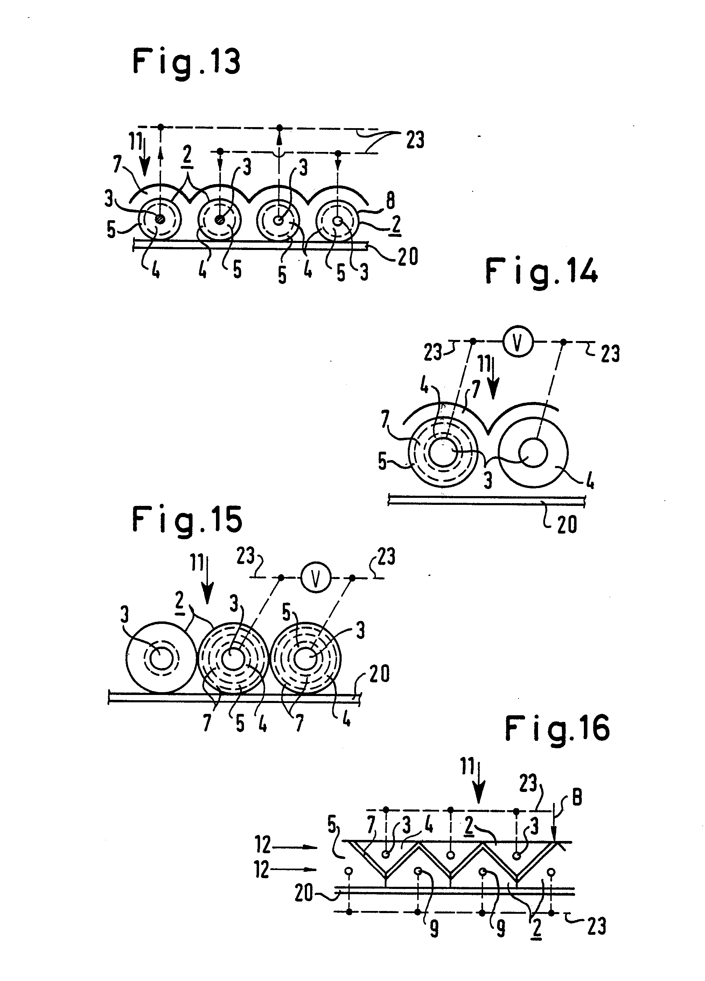

Gemäß Fig. 13 sind mehrere Solarzellen 2 auf Abstand voneinander und parallel zueinander auf einem Träger 20 angeordnet. Je zwei benachbarte Solarzellen 2 besitzen einen jeweils umgekehrten Schichtaufbau, sodaß jeweils zwei nebeneinanderliegende Mitelelektroden 3 die elektrischen Gegenpole bilden und an unterschiedliche Stromschienen 23 angeschlossen sind - entsprechend auch Fig. 12.

Statt einer eventuellen Kontaktverstärkung 10a in Fig. 12 sind in Fig. 13 die fadenförmigen Solarzellen 2 in eine i-Schicht 7 eingebettet und über diese miteinander in Tandem-Schaltung verbunden.

In Fig. 14 ist auch innerhalb der Ummantelung 6, und zwar an der Stelle der Sperrschicht 6 eine solche i-Schicht 7 zur Vergrößerung der Sperrschicht vorgesehen.

In Fig. 15 berühren sich die parallel nebeneinanderangeordneten Solarzellen 2 über eine zusätzliche Ummantelungs-i-Schicht 7.

Gemäß Fig. 16 liegt eine etwa Fig. 9 entsprechende Abwandlung einer lagenweisen Solarzellen-Anordnung 1 vor, und zwar unter Einfügung einer i-Schicht 7 welche gemäß Pfeil B auch bis an die lichtseitige Oberfläche der Anordnung ragt. In Fig. 16 sind die übereinanderliegenden Parallel-Lagen 12 unterschiedlich aufgebaut. Die Mittelelektroden 3 der oberen Parallel-Lage 12 sind mit einer n-Schicht 4 ummantelt, während die unteren Elektroden - als Gegenelektroden 9 - mit einer p-Schicht 5 ummantelt sind. Die Beschichtungen beider. Elektroden können mit einer i-Schicht 7 miteinander elektrisch verbunden sein.

Die vorstehenden beispielsmäßig angegebenen Ausführungsformen zeigen die Vielfalt an Einsatzmöglichkeiten vonfaden-bzw. drahtförmigen Solarzellen auch in verschiedensten Elektrodenanordnungen auf.

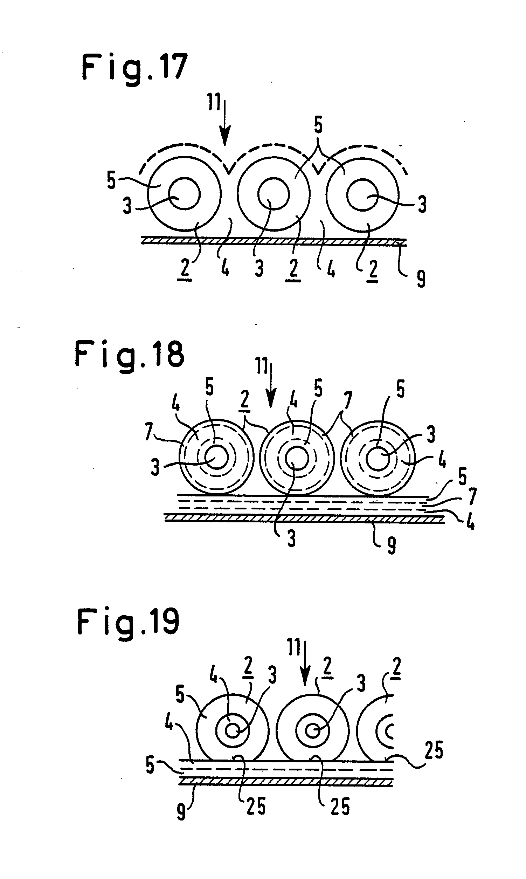

Die Fig. 17 und 18 zeigen weitere Ausführungsformen von Solarzellen-Anordnungen 1, bei denen parallel nebeneinanderliegende Mittelelektroden 3 lediglich mit einer Halbleiterschicht - entweder einer Ummantelung als p-Schicht 5 oder als n-Schicht 4 - ummantelt sind. Zur Vervollständigung als Solarzelle 2 sind diese in eine Schicht des jeweils anderen Materials (n-bzw. p-Material) eingebettet und mit einem elektrisch leitenden Träger als Gegenelektrode 9 verbunden. Als äußere Ummantelung um das Fadenelement kann auch noch eine i-Schicht zwischen die p-und die n-Schicht eingefügt sein. Auch kann diese Solarzelle 2 auf ihrer Lichteinfallsseite konvex profiliert sein.

In Fig. 18 sind nebeneinanderliegende Solarzellen-Elemente, welche sich umfangsmäßig nicht berühren, auf einer mit photovoltaisch wirksamem Material beschichteten Gegenelektrode 9 angeordnet. Die oberste p-Schicht 5 der Beschichtung der Gegenelektrode steht dabei jeweils über eine i-Schicht (7)-Ummantelung auf einer n-Schicht 4 mit einer die Mittelelektrode 3 umgebenden p-Schicht 5 in Verbindung, sodaß zwischen der Gegenelektrode 9 und der jeweiligen Mittelelektrode 3 eine Tandem-Zelle gegeben ist. Dabei ist die Einfügung einer i-Schicht bzw. auch weiterer i-Schichten ausdrücklich rein alternativ.

Gemäß Fig. 19 können bei der Kombination faden-bzw. drahtförmiger Solarzellen 2 mit flächigen Solarzellen-Strukturen die Kontaktflächen zwischen den verschiedenen Zellenarten durch einseitige Abflachung oder Materialabtragung Kontaktflächen-Vergrößerungen 25 geschaffen werden, um den Innenwiderstand der Solarzellen zu reduzieren. Alternativ können sich in Fig. 19 die einzelnen Solarzellen 2 auch seitlich eng evtl. ebenfalls abgeflacht berühren. Derartige Kontaktflächen-Vergrößerungen gelten gegebenenfalls auch für sämtliche vorhergehenden Ausführungsformen.

## BEZUGSZEICHENLISTE

1 Solarzellenanordnung
2 Faden-bzw. drahtförmige Solarzelle Solarzellen-Element (2′ kleiner Querschnitt)
(2″ abgeflachter Querschnitt)
3 Mittelelektrode
3a Kontaktbereich
4 Halbleiterschicht (n)
5 Halbleiterschicht (p)
6 Ummantelung = photovoltaische Schicht

7 intrinsische, undotierte i-Schicht

8 Sperr-bzw. übergangschicht

9 Gegenelektrode

9a Gegenelektrode als Wendel

10 Außenseite der fadenförmigen Solarzelle

10a Kontaktstelle, Kontaktverstärkung

11 dem Lichteinfall zugewandte Seite der fadenförmigen Solarzelle

12 Parallel-Lagenanordnung

13 Gewebeanordnung

13a Kontaktverstärkung

14 Vlies-Anordnung

15 Endabschnitt

16 Verspiegelung

17 Isolation (transparente Kunststoffumhüllung)

18 Konvexform

20 Träger

22 Faden-Gegenelektrode

23 Stromschiene

24 (flächige) Stromleiterbahn

25 Kontaktflächen Vergrößerung

## Ansprüche

1. Solarzellenanordnung mit mehreren Solarzellen-Elementen, welche eine photovoltaische Schicht rings um eine langgestreckte Elektrode herum aufweisen,
dadurch gekennzeichnet, daß jedes Solarzellen-Element (2) als ganzes für sich eine einzelne, gesonderte Spannungszelle mit einer Gegenelektrode (9) bildet.

2. Solarzellenanordnung nach Anspruch 1,
dadurch gekennzeichnet, daß als Gegenelektrode (9) eine elektrisch leitende Wendel (9a) auf dem Umfang (10) jedes Solarzellen-Elements (2) vorgesehen ist.

3. Solarzellenanordnung nach Anspruch 1,
dadurch gekennzeichnet, daß mehrere Solarzellen-Elemente (2) an ihrem Umfang (10) mit mindestens einer, in deren Längsrichtung angeordneten faden-bzw. drahtförmigen Gegenelektrode (9) in elektrisch leitendem Kontakt stehen.

4. Solarzellenanordnung nach Anspruch 1,
dadurch gekennzeichnet, daß mehrere Solarzellen-Elemente (2) an ihrem Umfang (10) mit einer flächigen Gegenelektrode (9) in elektrisch leitendem Kontakt stehen.

5. Solarzellenanordnungn nach Anspruch 1,
dadurch gekennzeichnet, daß die Solarzellen-Elemente (2) an ihrem Umfang (10) untereinander in elektrisch leitendem Kontakt stehen.

6. Solarzellenanordnung nach Anspruch 1,
dadurch gekennzeichnet, daß jedes Solarzellen-Element (2) auf seinem Umfang (10) an der dem Lichteinfall abgewandten Seite eine elektrisch leitende, vorzugsweise zu der dem Lichteinfall zugewandten Seite (11) reflektierende Schicht als Gegenelektrode (9; Fig. 3) aufweist.

7. Solarzellenanordnung nach Anspruch 1,
dadurch gekennzeichnet, daß jedes Solarzellen-Element (2) für sich als Gegenelektrode (9) mit einer mindestens teiltransparenten, elektrisch leitenden Kunststoffschicht umhüllt oder mehrere Solarzellen-Elemente darin eingebettet sind.

8. Solarzellenandordnung nach Anspruch 1,
dadurch gekennzeichnet, daß jedes Solarzellen-Element (2) für sich mit einer elektrisch isolierenden, transparenten Kunststoffschicht (17; Fig. 4) umhüllt ist und mindestens jeweils zwei elektrisch zusammengeschaltete Solarzellen-Elemente photovoltaisch einander entgegengesetzt beschichtet sind.

9. Solarzellenanordnung nach einem der vorhergehenden Ansprüche,
dadurch gekennzeichnet, daß mehrere Solarzellen-Elemente (2) in einer Ebene (12) parallel nebeneinander angeordnet sind (z.B. Fig. 1).

10. Solarzellenanordnung nach einem der vorhergehenden Ansprüche,

**dadurch gekennzeichnet**, daß mehrere Solarzellen-Elemente (2) in mehr als einer Lage (12) mit vorzugsweise seitlich zueinander versetzten Mittelelektroden (3) übereinander und in elektrischem Kontakt an ihrem Umfang (10), insbesondere auch mit unterschiedlichen Durchmessern und/oder voneinander verschiedener Lichtempfindlichkeit auf einer gemeinsamen zur Lichteinfallsseite hin vorzugsweise lichtreflektierenden Gegenelektrode (9) angeordnet sind.

11. Solarzellenanordnung nach einem der vorhergehenden Ansprüche,

**dadurch gekennzeichnet**, daß die einzelnen Solarzellen-Elemente (2) fadenförmig, vorzugsweise mit rundem oder elliptischem Querschnitt ausgebildet sind bzw. vorzugsweise zur Lichteinfallsseite eine konvexe Oberfläche aufweisen.

12. Solarzellenanordnung nach einem der vorhergehenden Ansprüche,

**dadurch gekennzeichnet**, daß die Solarzellen-Elemente (2) zu insbesondere im Querschnitt polygonen, vorzugsweise dreieckigen oder elliptisch abgeflachtem Querschnitt geformt sind.

13. Solarzellenanordnung nach einem der vorhergehenden Ansprüche,

**dadurch gekennzeichnet**, daß die einzelnen Soalrzellen-Elemente (2) miteinander verwebt oder vliesartig verbunden sind, wobei als Gegenelektrode (9) vorzugsweise eine flächige, insbesondere folienartige Stromleiterbahn (24) auf der dem Licht abgewandten Seite (11) vorgesehen ist.

14. Solarzellenanordnung insbesondere nach einem der vorhergehenden Ansprüche,

**dadurch gekennzeichnet**, daß bei einer als Gewebe gebildeten Solarzellenanordnung die Schußfäden bildenden Solarzellen-Elemente (2) um die Mittelelektrode (3) herum entgegengesetzt angeordnete photovoltaisch wirksame Schichten (4 bzw. 5) aufweist, welche vorzugsweise an den Gewebekreuzungen in bevorzugt elektrisch leitendem Kontakt stehen, und daß die Mittelelektroden (3) der Schußfäden und die Mittelelektroden (3) der Kettfäden die Gegenpole der tandem-mäßig geschalteten Gewebefäden sind.

15. Solarzellenanordnung nach Anspruch 14,

**dadurch gekennzeichnet**, daß das Gewebe teilweise lichtdurchlässig gewebt ist.

16. Solarzellenanordnung nach einem der vorhergehenden Ansprüche,

**dadurch gekennzeichnet**, daß die faden-bzw. drahtförmige Mittelelektrode (3) metallisch und/oder meatllisiert und/oder aus Carbonfasern und/oder elektrisch leitendem Kunststoff besteht.

17. Solarzellenanordnung nach Anspruch 10,

**dadurch gekennzeichnet**, daß die Mittelelektrode (3) im Vergleich zur photovoltaischen Ummantelung (6) die überwiegende Querschnittsfläche einnimmt.

18. Solarzellenanordnung insbesondere nach einem der vorhergehenden Ansprüche,

**dadurch gekennzeichnet**, daß die photovoltaische Schicht (6; 4, 5; 7) aus flexiblem organischem Material, insbesondere Kunststoff, besteht, beispielsweise aus Schichten verschiedener Kunststoffverbindungen.

19. Solarzellenanordnung insbesondere nach einem der vorhergehenden Ansprüche,

**dadurch gekennzeichnet**, daß die verschiedenen photovoltaischen Schichten (6; 4, 5; 7) kombiniert aus photoaktiven organischen und anorganischen Substanzen kombiniert sind.

20. Solarzellenanordnung insbesondere nach einem der vorhergehenden Ansprüche,

**dadurch gekennzeichnet**, daß sie Farbsensibilisatoren aufweist.

21. Solarzellenanordnung insbesondere nach einem der vorhergehenden Ansprüche,

**dadurch gekennzeichnet**, daß Aktivatoren zur Sensibilisierung photoaktiver Substanzen vorgesehen sind.

22. Solarzellenanordnung insbsondere nach einem der vorhergehenden Ansprüche 1 bis 21,

**dadurch gekennzeichnet**, daß die einzelnen Solarzellen-Elemente (2) in eine Schicht aus intrinsischundotiertem Material (7; i-Schicht) eingebettet und jeweils zwei nebeneinanderliegende Solarzellen-Elemente (2) photovoltaisch entgegengesetzt zueinander ausgebildet sind.

23. Solarzelleanordnung insbesondere nach einem der vorhergehenden Ansprüche,

**dadurch gekennzeichnet**, daß bei den einzelnen Solarzellen-Elementen (2) zwischen zwei photoaktiven Schichten (p-n bzw. n-p) jeweils eine intrinsische, undotierte i-Schicht (7) vorgesehen ist.

24. Solarzellenanordnung insbesondere nach einem der vorhergehenden Ansprüche,

**dadurch gekennzeichnet**, daß eine Mittelelektrode (3) mit dem einen photoaktiven Material (p,5 bzw. n,4) und die andere Mittelelektrode (3) mit den jeweils anderen photoaktiven Material (n,4 bzw. p,5) beschichtet ist, und daß sich diese Beschichtungen an einer Grenzschicht (pn-übergang) berühren, gegebenenfalls unter Zwischenschaltung einer i-Schicht (7) (z.B. Fig. 16).

25. Solarzellenanordnung insbesondere nach einem der vorhergehenden Ansprüche,

**dadurch gekennzeichnet**, daß die Mittelelektroden (3) jeweils nur mit dem einen photoaktiven Material (p,5 bzw. n,4) beschichtet und damit gemeinsam in eine Schicht aus dem jeweils anderen photoaktiven Material (n,4 bzw. p,5) eingebettet sind, an der die Gegenelektrode (9) anliegt (z.B. Fig. 17).

12

26. Solarzellenanordnung insbesondere nach einem der vorhergehenden Ansprüche,

**dadurch gekennzeichnet**, daß jeweils mit. umeinanderliegenden p-und n-Schichten (4, 5) beschichtete Mittelelektroden (3) als fadenförmige Solarzellen-Elemente (2) in elektrischer Verbindung auf einer mit photovoltaischen Schichten beschichteten flächigen Gegenelektrode (9) angeordnet sind, und zwar derart, daß die p-Schicht (5) der Mittelelektrode (3) mit der n-Schicht (4) der Gegenelektrode (9) - oder umgekehrt - in Kontakt stehen.

27. Elektrodenanordnung für eine Solarzellenanordnung insbesondere nach einem der vorhergehenden Ansprüche,

**dadurch gekennzeichnet**, daß parallel nebeneinander oder auch übereinander und im Winkel zueinander liegende faden-bzw. drahtförmige Mittelelektroden (3) über ihre umhüllenden photoaktiven Schichten (6) elektrisch miteinander verbunden sind.

28. Elektrodenanordnung für eine Solarzellenanordnung insbesondere nach einem der vorhergehenden Ansprüche,

**dadurch gekennzeichnet**, daß den parallel nebeneinanderliegenden faden-bzw. drahtförmigen Mittelelektroden (3) eine auf dem dem Lichteinfall abgewandten Seite angeordnete flächige Gegenelektrode (9) gemeinsam zugeordnet ist, welche über mindestens den größten Teil der Längserstreckung der Solarzellen (2) mit der Außenseite (10) ihrer Halbleitermaterial-Umhüllung (6) elektrisch leitend verbunden ist.

29. Verfahren zur Herstellung einer Solarzellenanordnung aus faden-bzw. drahtförmigen Solarzellen insbesondere nach einem der vorhergehenden Ansprüche,

**dadurch gekennzeichnet**, daß eine faden-bzw. drahtförmige metallische bzw. elektrisch leitende Mittelelektrode im kontinuierlichen Verfahren nacheinander Reinigungs-, Beschichtungs-, Dotierungs-und Wärmebehandlungsstufen unterworfen und der mit der fertigen photoaktiven Beschichtung versehene kontinuierliche Strang zu einem Gewebe verbunden wird.

30. Verfahren zur Herstellung einer Solarzellenanordnung aus faden-bzw. drahtförmigen Solarzellen insbesondere nach einem der vorhergehenden Ansprüche,

**dadurch gekennzeichnet**, daß eine faden-bzw. drahtförmige metallische bzw. elektrisch leitende Mittelelektrode im kontinuierlichen Verfahren nacheinander Reinigungs-, Beschichtungs-, Dotierungs-und Wärmebehandlungsstufen unterworfen und der mit der fertigen photoaktiven Beschichtung versehene kontinuierliche Strang in bestimmte Längen unterteilt wird und die Strangteilstücke einander zugeordnet werden.

Fig.1

Fig.2

Fig.3

Fig.4

Fig.5

Fig.6

Fig.7

Fig.8

Fig.11

Fig.9

Fig.12

Fig.10

# Fig.13

# Fig.14

# Fig.15

# Fig.16

**Fig.17**

**Fig.18**

**Fig.19**